(19) Europäisches Patentamt

European Patent Office

Office européen des brevets

(11) **EP 1 411 581 B1**

(12) **FASCICULE DE BREVET EUROPEEN**

(45) Date de publication et mention
de la délivrance du brevet:
**13.07.2005 Bulletin 2005/28**

(51) Int Cl.⁷: **H01M 10/48**, G01R 31/36,
H01M 16/00

(21) Numéro de dépôt: **03300165.2**

(22) Date de dépôt: **16.10.2003**

(54) **Dispositif pour diagnostiquer l'état de corrosion d'une batterie notamment de véhicule automobile**

Vorrichtung zur Feststellung des Korrosionszustandes einer Batterie, insbesondere einer Autobatterie

Device for diagnosing the state of corrosion of a battery, in particular that of a vehicle

(84) Etats contractants désignés:
**BE DE ES FR GB IT**

(30) Priorité: **16.10.2002 FR 0212869**

(43) Date de publication de la demande:
**21.04.2004 Bulletin 2004/17**

(73) Titulaire: **Renault s.a.s.**
**92100 Boulogne Billancourt (FR)**

(72) Inventeurs:
• **Hiron, Christian**
**78690 Les Essarts le Roi (FR)**

• **Menourie, Sébastien**
**91150 Etampes (FR)**

(74) Mandataire: **Davies, Owen Robert Treharne**
**Renault SAS**
**Technocentre**
**TCR-GRA-1-55**
**1, avenue du Golf**
**78288 Guyancourt Cedex (FR)**

(56) Documents cités:
**US-A- 3 758 345**     **US-A- 4 467 017**
**US-A- 5 250 904**     **US-A- 5 627 472**

# Description

La présente invention se rapporte à un dispositif pour diagnostiquer l'état de corrosion d'une batterie notamment de véhicule automobile.

On connaît de la technique antérieure un certain nombre de méthodes pour estimer l'état de charge d'une batterie. Dans quelques unes de ces méthodes, classiquement, on mesure une variation de tension correspondant à une variation de courant aux bornes de la batterie pour une température donnée, et on déduit de cette mesure une image de la résistance interne de la batterie. On compare ensuite cette image à une base de données préétablie, et on déduit de cette comparaison l'état de charge de la batterie.

Le document US-5744962 propose un dispositif de surveillance de batterie par contrôle de leur résistance interne. Ceci constitue un dispositif séparé de la batterie.

Le document US-5627472 propose un dispositif avec une cellule coulométrique connecté à une cellule auxiliaire et montée à l'extérieur de la cellule. Ce dispositif n'est pas acceptable pour surveiller les batteries au plomb.

Bien que ces méthodes soient en général assez efficaces, elles ne permettent pas de diagnostiquer de manière fiable une cause très fréquente de défaillance des batteries, à savoir la corrosion de certaines des électrodes due à l'électrolyte (en général de l'acide sulfurique).

Ceci est vrai en particulier lorsqu'une batterie est presque complètement chargée, car alors sa résistance interne est sensiblement indépendante du degré de corrosion de ses électrodes.

La présente invention a pour but de fournir des moyens améliorés pour diagnostiquer de manière fiable le degré de corrosion des électrodes d'une batterie pour véhicule.

On atteint ce but de l'invention avec un dispositif pour diagnostiquer l'état de corrosion d'une batterie au plomb, de préférence une batterie prévue pour un véhicule, comprenant des électrodes immergées dans un électrolyte, remarquable en ce qu'il comprend :

a) au moins une pile témoin destinée à être soumise aux mêmes conditions de température que ladite batterie, cette pile étant choisie de manière que l'évolubon de sa force électromotrice au cours du temps soit représentative de l'évolution du degré de corrosion de parties de certaines desdites électrodes au cours du temps,

b) des moyens pour mesurer ladite force électromotrice, et

c) un logement destiné à tremper en permanence dans ledit électrolyte et dans lequel est logé ladite pile témoin.

Grâce à ces caractéristiques, une simple mesure de la force électromotrice de la pile permet d'obtenir une indication fiable sur le degré de corrosion de parties de certaines des électrodes de la batterie.

Il n'est donc nécessaire ni de recourir à quelque mesure de tension ou de courant aux bornes de la batterie que ce soit, ni d'utiliser des moyens de calculateur ou de dispositifs complètement externes. L'invention permet en outre de protéger la pile de l'effet de la corrosion due à l'électrolyte de la batterie.

Suivant d'autres caractéristiques du dispositif selon l'invention :

- ledit dispositif comprend un tube étanche au fond duquel est placée ladite pile témoin, ledit tube étanche étant destiné à tremper en permanence dans ledit électrolyte,
- ledit tube étanche est formé d'une seule pièce avec le couvercle de ladite batterie,
- ladite pile témoin est une pile bouton,
- ladite pile témoin est une pile du type Zinc/Manganèse,
- des fils sont soudés aux deux pôles de ladite pile, de manière à dépasser au-dessus de ladite batterie,
- ledit dispositif comprend une pluralité de piles témoins.

La présente invention se rapporte également à une batterie comprenant des électrodes immergées dans un électrolyte, remarquable en ce qu'elle est équipée d'un dispositif conforme à ce qui précède pour diagnostiquer le degré de corrosion de parties de certaines desdites électrodes.

Suivant d'autres caractéristiques de cette batterie :

- ledit dispositif est intégré au couvercle de ladite batterie,
- lesdites certaines électrodes sont des anodes,
- lesdites parties d'électrodes sont des grilles métalliques desdites anodes.

La présente invention se rapporte également à un procédé de sélection d'une pile témoin pour un dispositif conforme à ce qui précède destiné à équiper une batterie au plomb, de préférence une batterie prévue pour un véhicule, conforme à ce qui précède, remarquable en ce qu'il comprend les étapes consistant à :

- analyser l'évolution dans le temps des performances de ladite batterie pour une température prédéterminée,
- analyser l'évolution dans le temps de la force électromotrice de piles soumises à la même température que ladite température prédéterminée, et à
- sélectionner, parmi lesdites piles, celle dont la force électromotrice évolue dans le temps de la manière la plus proche des performances de ladite batterie.

L'invention va maintenant être décrite à titre d'exemple illustratif et non limitatif en référence aux figures dans lesquelles:

- la figure 1 est une vue partielle en coupe d'une batterie équipée du dispositif selon l'invention,
- la figure 2 est une vue en coupe de détail du dispositif selon l'invention, et
- la figure 3 est un graphique montrant l'évolution au cours du temps de la force électromotrice d'une pile pour différentes températures.

Dans ce qui suit avec les références aux figures, on va décrire le dispositif selon l'invention dans le cas particulier où il est installé sur une batterie de plomb notamment de véhicule automobile, mais il va de soi qu'un tel dispositif pourrait être installé sur plusieurs types d'accumulateur.

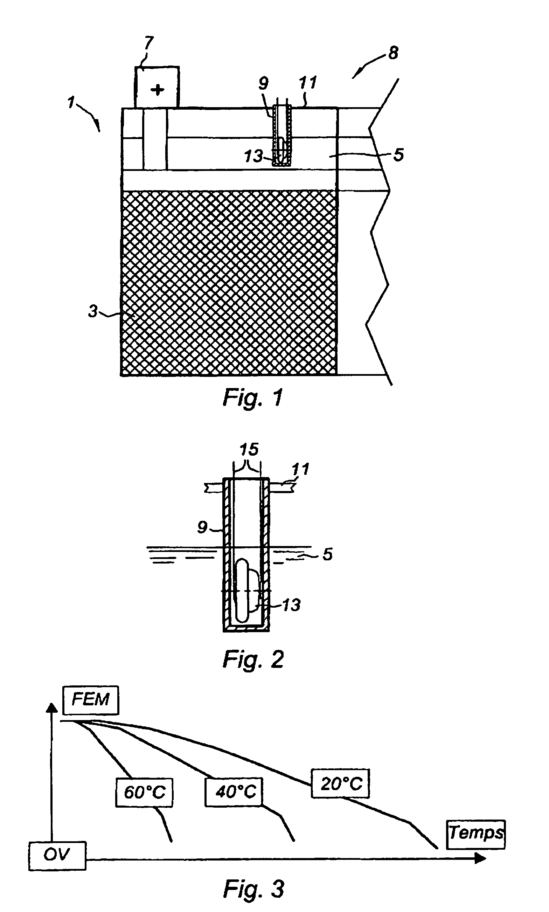

On se reporte à présent à la figure 1, sur laquelle on a représenté une batterie 1 comprenant un faisceau d'électrodes 3 immergées dans un électrolyte 5. Le faisceau d'électrodes 3 comprend des électrodes négatives (ou cathodes) et des électrodes positives (ou anodes) disposées en sandwich de manière alternée.

Classiquement, les cathodes peuvent être formées par des plaques de plomb, et les anodes peuvent être formées par des grilles métalliques supportant du peroxyde de plomb. Les cathodes et les anodes sont reliées en série respectivement à des bornes négative (non représentée) et positive 7 fixées sur la partie supérieure 8 de la batterie 1. Classiquement, l'électrolyte 5 peut être formé par de l'acide sulfurique légèrement dilué. L'équation chimique gouvernant alors la décharge de ce type de batterie dite " au plomb " est alors :

$$Pb + PbO_2 + 2H_2O_4 \rightarrow 2SO_4Pb + 2H_2O$$

Comme cela est visible sur la figure 1, le dispositif selon l'invention comprend un logement en forme de tube de préférence étanche 9 (formé par exemple en matière plastique) fixé, formé ou intégré sur le couvercle 11 de la batterie 1. De manière optionnelle, le tube étanche 9 peut être moulé d'une seule pièce avec le couvercle 11.

Pour plus de détail sur ce dispositif, on se reporte à la figure 2, sur laquelle on voit que la partie inférieure du tube étanche 9 est immergée en permanence dans l'électrolyte 5. Une pile témoin 13 est placée au fond du tube étanche 9, de manière à être soumise sensiblement à la même température que l'électrolyte 5. La pile témoin 13 peut par exemple être une pile bouton du type Zinc/Manganèse, disponible dans le commerce. Deux fils 15 sont soudés aux pôles positif et négatif de la pile témoin 13, et sortent du tube étanche 9 au-dessus du niveau du couvercle 11 de la batterie 1.

Le dispositif selon l'invention comprend également des moyens de mesure de la force électromotrice de la pile témoin 13, ces moyens étant soit branchés de manière permanente aux fils 15, soit branchés chaque fois que l'on souhaite effectuer une mesure. Ces moyens de mesure peuvent être des dispositifs connus en soi (voltmètre, par exemple), et ne seront donc pas exposés plus en détail ici.

On se reporte à la figure 3, sur laquelle on a représenté des courbes montrant l'évolution de la force électromotrice de la pile témoin 13 au cours du temps pour différentes températures, à savoir 20°C, 40°C et 60°C. Comme cela apparaît clairement sur cette figure, la force électromotrice de la pile témoin 13 décroît d'autant plus rapidement dans le temps que la température à laquelle elle est soumise est élevée.

Le mode de fonctionnement et les avantages du dispositif selon l'invention résultent clairement de la description qui précède. La décroissance dans le temps de la force électromotrice de la pile 13 est due principalement à deux phénomènes : d'une part à l'autodécharge de cette pile, et d'autre part à son vieillissement lié notamment à la corrosion. Ces deux phénomènes sont fortement accentués par la température à laquelle la pile témoin 13 est soumise. Il en est de même pour le phénomène de corrosion des grilles métalliques formant les anodes de la batterie 1 : plus la température est élevée, plus ces grilles se dégradent rapidement.

On comprend donc qu'en choisissant correctement la pile témoin 13 (type, taille, qualité...), sa dégradation, et donc l'évolution de sa force électromotrice, pourra être représentative de la dégradation des grilles des anodes de la batterie 1.

Ainsi, en mesurant la force électromotrice de la pile témoin 13, on obtient une image fidèle du degré de corrosion des anodes de la batterie 1 : la pile témoin 13 joue en quelque sorte un rôle de capteur d'état de corrosion de la batterie 1. Comme on peut le comprendre à la lumière de ce qui précède, le dispositif selon l'invention ne nécessite aucune mesure de tension ou de courant aux bornes de la batterie, et ne fait intervenir aucun moyen complexe tel qu'un calculateur électronique.

Le dispositif selon l'invention est donc simple et peu coûteux, ce qui permet d'envisager de le monter de série sur les batteries au plomb sans qu'il soit nécessaire d'augmenter de manière significative le prix de ces dernières. La force électromotrice de la pile témoin 13 peut être surveillée de manière continue par un calculateur de véhicule automobile, ou épisodiquement lors d'opérations d'entretien.

Pour sélectionner correctement la pile témoin 13 (type, taille, qualité...), on commence par effectuer un test de durée de vie de la batterie 1. Ce test, qui s'effectue dans des conditions normalisées, consiste à plonger la batterie 1 dans un bain à 60°C, et à mesurer ses performances (courant, tension) au cours du temps. Lorsque ces performances descendent en dessous d'un seuil prédéterminé, la batterie est déclarée hors service et le temps écoulé jusqu'à ce seuil est noté et constitue une caractéristique de la batterie. Parallèlement, on teste de manière similaire des piles de types, de tailles et de qualités différentes.

On déduit aisément de ces tests la pile dont la force électromotrice se dégrade au cours du temps de manière comparable aux performances de la batterie. Pour augmenter la précision des informations fournies par le dispositif selon l'invention, il est tout à fait possible d'utiliser non pas une, mais plusieurs piles témoins identiques ou de tailles différentes.

## Revendications

1. Dispositif pour diagnostiquer l'état de corrosion d'une batterie (1) au plomb, de préférence une batterie prévue pour un véhicule, comprenant des électrodes immergées dans un électrolyte (5), **caractérisé en ce qu'**il comprend :

   a) au moins une pile témoin (13) destinée à être soumise aux mêmes conditions de température que ladite batterie (1), cette pile étant choisie de manière que l'évolution de sa force électromotrice au cours du temps soit représentative de l'évolution du degré de corrosion de parties de certaines desdites électrodes au cours du temps,
   b) des moyens pour mesurer ladite force électromotrice, et
   c) un logement (9) destiné à tremper en permanence dans ledit électrolyte (5) et dans lequel est logé ladite pile témoin (13).

2. Dispositif selon la revendication 1, **caractérisé en ce que** ledit logement comprend un tube (9) étanche au fond duquel est placée ladite pile témoin (13), ledit tube étanche (9) étant destiné à tremper en permanence dans ledit électrolyte (5).

3. Dispositif selon la revendication 2, **caractérisé en ce que** ledit tube étanche (9) est intégré ou formé d'une seule pièce avec le couvercle (11) de ladite batterie (1).

4. Dispositif selon l'une quelconque des revendications précédentes, **caractérisé en ce que** ladite pile témoin (13) est une pile bouton.

5. Dispositif selon l'une quelconque des revendications précédentes, **caractérisé en ce que** ladite pile témoin (13) est une pile du type Zinc/Manganèse.

6. Dispositif selon l'une quelconque des revendications précédentes, **caractérisé en ce que** des fils (15) sont soudés aux deux pôles de ladite pile (13), de manière à dépasser au-dessus de ladite batterie (1).

7. Dispositif selon l'une quelconque des revendications précédentes, **caractérisé en ce qu'**il comprend une pluralité de piles témoins.

8. Batterie (1) comprenant des électrodes (3) immergées dans un électrolyte (5), **caractérisée en ce qu'**elle est équipée d'un dispositif conforme à l'une quelconque des revendications précédentes pour diagnostiquer le degré de corrosion de parties de certaines desdites électrodes (3).

9. Batterie (1) selon la revendication 8, **caractérisée en ce que** ledit dispositif est intégré au couvercle de ladite batterie (1).

10. Batterie (1) selon l'une des revendications 8 ou 9, **caractérisée en ce que** lesdites certaines électrodes sont des anodes.

11. Batterie (1) selon la revendication 10, **caractérisée en ce que** lesdites parties d'électrodes sont des grilles métalliques desdites anodes.

12. Procédé de sélection d'une pile témoin (13) pour un dispositif conforme à l'une quelconque des revendications 1 à 7 destiné à équiper une batterie (1) au plomb d'un véhicule, conforme à l'une quelconque des revendications 8 à 11, **caractérisé en ce qu'**il comprend les étapes consistant à :

   - analyser l'évolution dans le temps des performances de ladite batterie (1) pour une température prédéterminée,
   - analyser l'évolution dans le temps de la force électromotrice de piles soumises à la même température que ladite température prédéterminée, et à
   - sélectionner, parmi lesdites piles, celle (13) dont la force électromotrice évolue dans le temps de la manière la plus proche des performances de ladite batterie (1).

## Patentansprüche

1. Vorrichtung zum Diagnostizieren des Korrosionszustands einer Batterie (1) mit Blei, vorzugsweise eine Batterie, die für ein Fahrzeug vorgesehen ist, aufweisend Elektroden, die in ein Elektrolyt (5) eingetaucht sind, **dadurch gekennzeichnet, dass** sie aufweist:

   a) mindestens eine Kontrollbatterie (13), welche dafür bestimmt ist, den gleichen Temperaturbedingungen wie die Batterie (1) ausgesetzt zu werden, wobei diese Batterie derart ausgewählt wird, dass die Entwicklung ihrer elektromotorischen Kraft im Verlaufe der Zeit repräsentativ für die Entwicklung des Korrosionsgrades von Teilen bestimmter der genannten Elektroden über den Zeitverlauf ist;

b) Mittel zum Messen der elektromotorischen Kraft; und

c) eine Aufnahme (9), die dafür bestimmt ist, permanent in den Elektrolyt (5) eingetaucht zu sein, und in welcher die Kontrollbatterie (13) aufgenommen ist.

2. Vorrichtung nach Anspruch 1, **dadurch gekennzeichnet, dass** die Aufnahme ein dichtes Rohr (9) umfasst, auf dessen Boden die Kontrollbatterie (13) gesetzt ist, wobei das dichte Rohr (9) dafür bestimmt ist, permanent in dem Elektrolyt (5) eingetaucht zu sein.

3. Vorrichtung nach Anspruch 2, **dadurch gekennzeichnet, dass** das dichte Rohr (9) integriert ist oder aus einem Stück mit dem Deckel (11) der Batterie (1) gebildet ist.

4. Vorrichtung nach irgendeinem der vorhergehenden Ansprüche, **dadurch gekennzeichnet, dass** die Kontrollbatterie (13) eine Knopfbatterie ist.

5. Vorrichtung nach irgendeinem der vorhergehenden Ansprüche, **dadurch gekennzeichnet, dass** die Kontrollbatterie (13) eine Batterie vom Typ Zink/Mangan ist.

6. Vorrichtung nach irgendeinem der vorhergehenden Ansprüche, **dadurch gekennzeichnet, dass** die Drähte (15) an den zwei Polen an der Batterie (13) derart angeschweißt sind, um oberhalb der Batterie (1) vorzuragen.

7. Vorrichtung nach irgendeinem der vorhergehenden Ansprüche, **dadurch gekennzeichnet, dass** sie eine Mehrzahl von Kontrollbatterien aufweist.

8. Batterie (1), welche Elektroden (3) aufweist, die in einem Elektrolyt (5) eingetaucht sind, **dadurch gekennzeichnet, dass** sie mit einer Vorrichtung gemäß irgendeinem der vorhergehenden Ansprüche zum Diagnostizieren des Korrosionszustands von Teilen von bestimmten der Elektroden (3) ausgestattet ist.

9. Batterie (1) nach Anspruch 8, **dadurch gekennzeichnet, dass** die Vorrichtung im Deckel der Batterie (1) integriert ist.

10. Batterie (1) nach irgendeinem der Ansprüche 8 oder 9, **dadurch gekennzeichnet, dass** die bestimmten Elektroden Anoden sind.

11. Batterie (1) nach Anspruch 10, **dadurch gekennzeichnet, dass** die Teile der Elektroden metallische Gitter der Anoden sind.

12. Verfahren zur Auswahl einer Kontrollbatterie (13) für eine Vorrichtung entsprechend irgendeinem der Ansprüche 1 bis 7, die dafür bestimmt ist, eine Bleibatterie (1) eines Fahrzeuges auszustatten, entsprechend zu irgendeinem der Ansprüche 8 bis 11, **dadurch gekennzeichnet, dass** es die Schritte aufweist bestehend aus:

- Analysieren der Entwicklung über die Zeit der Leistungen der Batterie (1) für eine vorbestimmte Temperatur,

- Analysieren der Entwicklung über die Zeit der elektromotorischen Kraft von Batterien, welche der gleichen Temperatur wie der vorbestimmten Temperatur ausgesetzt sind, und

- unter den Batterien diejenige (13) auszuwählen, deren elektromotorische Kraft sich über die Zeit auf die am nahe kommenste Art und Weise zu den Leistungen der Batterie (1) entwickelt.

**Claims**

1. A device for diagnosing the state of corrosion of a lead battery (1), preferably a battery for a vehicle, comprising electrodes immersed in an electrolyte (5), **characterised in that** it comprises:

a) at least one indicator cell (13) adapted to be subject to the same temperature conditions as the battery (1), this cell being chosen such that the evolution of its electromotive force over time is representative of the evolution of the degree of corrosion of parts of some of the electrodes over time;

b) means for measuring this electromotive force;

c) a housing (9) adapted to be permanently immersed in the electrolyte (5) and in which the indicator cell (13) is housed.

2. A device as claimed in claim 1, characterise in that the housing comprises a leak-tight tube (9) on whose base the indicator cell (13) is disposed, the leak-tight tube (9) being adapted to be permanently immersed in the electrolyte (5).

3. A device as claimed in claim 2, **characterised in that** the leak-tight tube (9) is integrated in or formed in one piece with the cover (11) of the battery (1).

4. A device as claimed in any one of the preceding claims, **characterised in that** the indicator cell (13) is a button cell.

**5.** A device as claimed in any one of the preceding claims, **characterised in that** the indicator cell (13) is a cell of the zinc/manganese type.

**6.** A device as claimed in any one of the preceding claims, **characterised in that** wires (15) are welded to the two poles of the cell (13) so as to extend above the battery (1).

**7.** A device as claimed in any one of the preceding claims, **characterised in that** the device comprises a plurality of indicator cells.

**8.** A battery (1) comprising electrodes (3) immersed in an electrolyte (5), **characterised in that** it is equipped with a device as claimed in any one of the preceding claims in order to diagnose the degree of corrosion of parts of some of the electrodes (3).

**9.** A battery (1) as claimed in claim 8, **characterised in that** the device is integrated in the cover of the battery (1).

**10.** A battery (1) as claimed in one of claims 8 or 9, **characterised in that** some of the electrodes are anodes.

**11.** A battery (1) as claimed in claim 10, **characterised in that** the parts of the electrodes are metal grids of the anodes.

**12.** A method of selection of an indicator cell (13) for a device as claimed in any one of claims 1 to 7 adapted to equip a lead battery (1) of a vehicle as claimed in any one of claims 8 to 11, **characterised in that** it comprises the stages of:

- analysing the evolution over time of the performance of the battery (1) at a predetermined temperature;
- analysing the evolution over time of the electromotive force of cells subject to the same temperature as the predetermined temperature;
- selecting, from these cells, the cell (13) whose electromotive force evolves over time in the manner closest to the performance of the battery (1).

Fig. 1

Fig. 2

Fig. 3